# EUROPÄISCHE PATENTSCHRIFT

(11) **EP 3 789 148 B1**
(45) Veröffentlichungstag und Bekanntmachung des Hinweises auf die Patenterteilung: **17.07.2024**
(21) Anmeldenummer: 20193025.2
(22) Anmeldetag: 27.08.2020
(51) Int. Cl.: B23K 1/008, B23K 37/02, B23K 37/047, B23K 1/012, B23K 1/015, B23K 1/00

(54) **REFLOW-LÖTANLAGE ZUM KOMBINIERTEN KONVEKTIONSLÖTEN UND KONDENSATIONSLÖTEN**
REFLOW SOLDERING SYSTEM FOR COMBINED CONVECTION SOLDERING AND CONDENSATION SOLDERING
INSTALLATION DE SOUDAGE PAR REFUSION DESTINÉE AU SOUDAGE COMBINÉ DE SOUDAGE PAR CONVECTION ET DE SOUDAGE PAR CONDENSATION

(30) Priorität: 05.09.2019 DE 102019213511
(43) Veröffentlichungstag der Anmeldung: 10.03.2021
(73) Patentinhaber: Rehm Thermal Systems GmbH, 89143 Blaubeuren-Seissen (DE)
(72) Erfinder: Rehm, Johannes, 89143 Blaubeuren-Seissen (DE)
(74) Vertreter: Grünecker Patent- und Rechtsanwälte PartG mbB

(56) Entgegenhaltungen:
- EP-A2- 1 157 771
- EP-B2- 1 157 771
- WO-A2-03/106093
- DZIURDZIA BARBARA ET AL: "Voiding in lead-free soldering of components with large solder pads", PROCEEDINGS OF SPIE; [PROCEEDINGS OF SPIE ISSN 0277-786X VOLUME 10524], SPIE, US, vol. 10175, 22 December 2016 (2016-12-22), pages 1017506 - 1017506, XP060080249, ISBN: 978-1-5106-1533-5, DOI: 10.1117/12.2258608

## Beschreibung

### Gebiet der Erfindung

Die vorliegende Erfindung betrifft allgemein Reflow-Lötanlagen gemäß dem einleitenden Teil des Anspruches 1 (siehe z. B. EP 1 157 771 A2). Insbesondere betrifft die vorliegende Erfindung Reflow-Lötanlagen, die nach dem Konvektionsprinzip und dem Kondensationsprinzip arbeiten.

### Stand der Technik

Der Begriff Reflow-Löten oder Wiederaufschmelzlöten (engl.: reflow soldering) bezeichnet ein in der Elektrotechnik gängiges Weichlötverfahren zum Löten von elektronischen Bauteilen. Im ersten Schritt wird beim Reflow-Löten ein Weichlot in Form von Lotpaste vor der Bestückung auf ein Substrat wie beispielsweise eine Platine/Leiterplatte aufgetragen. Im nächsten Schritt werden dann Bauteile auf die klebrige Lotpaste gesetzt. Danach wird die bestückte Leiterplatte so erhitzt, dass das in der Lotpaste enthaltene Lot schmilzt.

Um beste Ergebnisse beim Reflow-Löten erzielen zu können, sollte vor jedem Prozess ein individueller Temperatur-Zeit-Verlauf, das so genannte "Reflow-Profil", ermittelt werden. Anhand dieser Analyse kann die Lötanlage hinsichtlich Prozessstabilität und Energieverbrauch auf die Fertigung eingestellt werden. Das Reflow-Profil ist abhängig von der thermischen Masse sowie Materialeigenschaften und Beschaffenheit der verschiedenen Bauelemente auf der Leiterplatte. Ohne eine spezifische Reflow-Profilierung ist es möglich, dass sensible Bauteile beispielsweise überhitzt, beschädigt oder instabil werden und somit in ihrer Funktion eingeschränkt sind. Weiterhin bestimmt der Temperatur-Zeitverlauf die Qualität der Lötstellen. Um diese Fehler zu minimieren, ist es vorteilhaft, ein optimales Temperaturprofil/Reflow-Profil abgestimmt auf ein zu fertigendes Produkt zu bestimmen.

Die dafür eingesetzten Heizverfahren haben das Ziel, die ermittelte Reflow-Profilierung effizient und akkurat umzusetzen. Dazu werden in der Elektronikfertigung verschiedene Wärmeübertragungsmechanismen wie beispielsweise "Konvektion" und "Kondensation" zum Löten elektronischer Baugruppen angewendet. Beide Verfahren bringen Ihre Vorteile und Nachteile mit, welche über den Einsatz des jeweiligen Verfahrens entscheiden.

### Konvektionslöten

Beim Konvektionslöten erfolgt der Lötprozess durch Konvektion, also durch das Mitführen von Wärme über strömende Gase, wie beispielsweise Luft oder Stickstoff. Das Konvektionslöten stellt aufgrund seiner Flexibilität beim Profilieren, der hohen Produktivität und einfacher Handhabung das am häufigsten angewendeten Verfahren dar. Als Wärmeübertragungsmedium werden Gase oder auch Gasgemische verwendet, wie z.B. Stickstoff oder Luft.

Die Nachteile des Konvektionslötverfahrens liegen darin, dass aufgrund der begrenzten Wärmeübertragung (Wärmeüberragungskoeffizient 30 bis 80 W/m²K) keine Löt-Baugruppen mit großen thermischen Massen verarbeitet werden können. Beim Reflowlöten werden wegen dieses Nachteils oft zu große Temperaturunterschiede zwischen den kleinen und großen thermischen Massen auf den Baugruppen erzeugt, die sich teilweise als Qualitätsmangel an den realisierten Lötstellen zeigen. Beim Konvektionslöten können auch die oberen Temperaturgrenzen überschritten werden, die seitens der Lötwärmebeständigkeit von z.B. elektronischen Bauelementen gegeben sind.

### Kondensationslöten (oder Dampfphasen-Löten)

Eine Kondensationslötanlage gemäß dem Stand der Technik wird beispielsweise in dem Europäischen Patent EP 931618 B1 beschrieben. Beim Kondensationslöten wird zur Wärmeübertragung eine Flüssigkeit (Wärmeübertragungsmedium bzw. Kondensationsmittel), in der Regel Perfluorierter Polyether (PFPE) mit einem Siedepunkt von z.B. 240 °C, verwendet. Kondensationslöten bietet eine Reihe von Vorteilen gegenüber Konvektionslöten. Beispielsweise wird beim Dampfphasen-Löten im Vergleich zum Konvektions-Reflow-Lötprozess etwa 10-mal mehr Energie pro Zeiteinheit zur Verfügung gestellt (Wärmeüberragungskoeffizient bis 300 W/m²K). Kondensationslöten bietet eine homogenere Wärmeverteilung aufgrund der Filmkondensation des Mediums im Vergleich zum Konvektionslöten. Das Kondensationsmittel erzeugt eine inerte Prozessumgebung, da PFPE inert ist. Überhitzungen können weitgehend vermieden werden, da die maximal erreichbare Temperatur durch das verwendete Medium (PFPE mit der Handelsbezeichnung Galden HS240) beispielsweise auf 240 °C begrenzt werden kann. Weiterhin bieten Kondensationslötanlagen eine hermetisch dichte Prozesskammer und ermöglichen dadurch einen Vakuumprozess. Auch im Hinblick auf das Residuemanagement (Abscheidung von Lötrauchen) sind die Anlagen nach dem Kondensationsprinzip den Konvektionslötanlagen überlegen. In der Konvektionslötanlage verdampfen die flüchtigen Bestandteile im Vorheiz- und Peakbereich. Bei einer Kondensationslötanlage nach EP 931618 B1 verdampfen alle Residues in einer geschlossenen Kammer. Die Residues werden mit dem Dampf (Gas / Fluid) evakuiert und gereinigt, wodurch die Prozesskammer stets sauber bleibt. Das führt zu deutlich kürzeren Wartungszeiten von Kondensationsanlagen im Vergleich zu Konvektionslötanlagen.

Die Nachteile des Kondensationslötens beispielsweise gemäß dem in dem Patent EP 931618 B1 (deutsche Übersetzung DE 699 07 767) beschriebenen Prinzips sind im Vergleich zum Konvektionslöten ein geringerer Durchsatz und geringere Flexibilität bei der Reflow-Profilierung. Diese geringere Flexibilität ergibt sich aus der Notwendigkeit, den Phasenwechsel des Mediums (gasförmig - flüssig) in nahezu geschlossenen Kammern durchzuführen, um den Medienverlust zu vermeiden. Aufgrund der verhältnismäßig langen Lötzeit in der Peak-Phase (d.h. der Phase mit Maximaltemperatur zum Aufschmelzen des Lots) kann das schnelle Abkühlen der Baugruppe die Qualität der Lötstelle verringern. Ist die Lötzeit in der Peak-Phase zu kurz, wird die Lotpaste nicht voll aufgeschmolzen. Ist dagegen die Zeit zu lang, wird u.a. die intermetallische Phase zu dick.

### Problembeschreibung

Die zunehmende Anwendung der Leistungs-Elektronik (Power-Elektronik) in den Fahrzeugen führt zu einer Steigerung der thermischen Masse elektronischer Baugruppen. Meist sind auf diesen Baugruppen (dem allgemeinen Trend der Elektronik folgend) auch sehr kleine Komponenten verarbeitet. Dies führt während des Reflowlötens zu einer Vergrößerung der Temperaturunterschiede zwischen den thermischen Massen (Leistungskomponenten und kleine Bauelemente).

Diese Faktoren führen zu einer zunehmenden Anwendung des Kondensationslötens auf Kosten der Flexibilität bei der Reflow-Profilierung und des Durchsatzes. Zum einen erfordern die zunehmenden Qualitätsstandards mehr Flexibilität bei der Reflow-Profilierung und zum anderen wünschen sich die Fertigungsstätten auch einen hohen Durchsatz (entsprechend den meist hohen Stückzahlen einer Automotiv-Produktion), der mit dem Kondensationsprinzip nur bedingt erreichbar ist. Zusätzlich machen die gestiegenen Anforderungen an die Lötstellenzuverlässigkeit Vakuumprozesse erforderlich, wie sie beispielsweise in der internationale Patentanmeldung WO 2005/087422 A1 beschrieben werden.

In Abhängigkeit von den Prozessanforderungen müssen sich die Anwender aktuell für das eine oder andere Verfahren und damit einen Anlagentyp entscheiden. Die Beschaffung von zwei Anlagentypen (Konvektion und Kondensation) wird aus finanziellen und platztechnischen Gründen sehr selten getätigt.

Wünschenswert wäre eine Anlage, mit der sich Konvektionslöten und Kondensationslöten kombinieren ließe. Eine Kombination von Konvektionslöten und Kondensationslöten wurde bis jetzt jedoch nicht in Erwägung gezogen, da die Konvektionsanlage ein offenes System ist, was wiederum ihr größter Vorteil ist, während die Kondensationsanlage ein geschlossenes System ist, was sowohl von Vorteil ist (Vakuum, Verschmutzung) als auch von Nachteil ist (geringer Durchsatz). Da ein System entweder nur offen oder geschlossen sein kann, ist eine Kombination eines offenen und eines geschlossenen Systems, das beide Vorteile vereint, schwer vorstellbar. Die unterschiedlichen Prinzipien (offen/geschlossen) machen ein Mischsystem auch anfälliger für Querkontamination.

Folgende zusätzlichen Schwierigkeiten ergeben sich aus der Kombination des offenen Systems zum Konvektionslöten und des geschlossenen Systems des Kondensationslötens:
- Das Durchlaufprinzip herkömmlicher Konvektionsanlagen macht es unmöglich, eine vollständig abgeschossene Kammer mit z.B. einer oder zwei Türen zu integrieren. Ein weiteres Problem ist die thermische Stabilisierung der geschlossenen Kammer. Sind die inneren Kammerwände nicht auf einer höheren Temperatur über dem Siedepunkt des Kondensations-Mediums Galden, entsteht nicht genügend Gas, um einen Kondensationslötprozess zu gestalten. Bei Integration des geschlossenen Systems in das offene System muss zwangsläufig das geschlossene System geöffnet werden, um den Übergang von Baugruppen von einem System ins Andere zu ermöglichen. Dies erschwert die thermische Stabilisierung des geschlossenen Systems.
- Bei üblichen Durchlauf-Kondensationsanlagen hat man es stets mit einem Verschmutzungsproblem der Prozesskammer zu tun, welches aufgrund der sich abscheidenden Lötrauche aus dem Lötgut entsteht. Diese Residues verschmutzen
- dabei die Prozesskammer des als geschlossenen System arbeitenden Kondensationslötprozesses und das im Kreislauf geführte Galden.

Es ist deshalb eine Aufgabe der vorliegenden Erfindung, eine Reflow-Lötanlage bereitzustellen, die flexibel komplexe Reflow-Profile und hohe Durchsätze bei gleichzeitig verbesserter Qualität der Lötstellen erlaubt.

Eine Dampfphasenlötanlage mit mehreren Prozess- bzw. Lötzonen wird beispielsweise in dem Dokument EP 1 157 771 A2 offenbart.

### Zusammenfassung

Die Aufgabe wird erfüllt durch eine Reflow-Lötanlage gemäß Anspruch 1. Die erfindungsgemäße Reflow-Lötanlage weist eine oder mehrere individuell beheizbare Löt-Prozesszonen auf. Weiterhin ist die erfindungsgemäße Reflow-Lötanlage konfiguriert, einem Werkstück Wärme "wahlweise" durch Kondensation oder durch Konvektion oder als Kombination aus Konvektion und Kondensation zuzuführen.

Um den oben genannten Anforderungen gerecht zu werden und die Verarbeitung verschiedener Baugruppen an einer Anlage sowohl nach dem Kondensations- als auch Konvektionsprinzip zu ermöglichen, werden in der vorliegenden Erfindung beide Verfahren derart vereinigt, dass die neuartige Anlage "wahlweise" mit dem Kondensationsverfahren, mit dem Konvektionsverfahren oder mit einer Kombination aus Konvektion und Kondensation arbeiten kann. Da die Anlage die verschiedenen Betriebsmodi wahlweise ausführen kann, ist die Anlage so aufgebaut, dass die nicht benötigten Komponenten stillgelegt werden können, ohne dass die restlichen Prozessabläufe behindert werden. D. h., wenn die Anlage in einem Betriebsmodus arbeitet, der nur Konvektionslöten erfordert, ist die Kondensationsprozesszone im Ruhezustand und die verarbeiteten Werkstücke können die Kondensationsprozesszone ungehindert passieren. Somit können sowohl die Vorteile der einzelnen Verfahren genutzt werden, als auch ein Kompromiss von Vor- und Nachteilen bei der Kombination von beiden Verfahren erzielt werden.

In einer Ausführungsform weist die Reflow-Lötanlage mindestens zwei Löt-Prozesszonen mit mindestens einer Kondensations-Prozesszone und mindestens einer dazu vorgelagerten oder nachgelagerten Konvektions-Prozesszone auf. Bei dieser Ausführungsform können für die Konvektions-Prozesszone Konvektionsmodule eingesetzt werden und für die Kondensations-Prozesszone können Kondensationsmodule verwendet werden. Die Prozessmodule können dabei einzelnen mit den individuellen Vorteilen oder in Kombination betrieben werden. In einem kombinierten Betriebsmodus kann bei einer vorliegenden Konvektions-Prozesszone das Konvektionsmodul zum Vorheizen verwendet werden. Der Peakbereich (Temperaturbereich zum Aufschmelzen des Lots (Löten)) kann dann im Kondensationsmodul realisiert werden. Bei einer nachgelagerten Konvektions-Prozesszone kann das Konvektionsmodul beispielsweise als Kühlzone konfiguriert werden.

In einer Weiterführung dieser Ausführungsform weist die Reflow-Lötanlage mindestens drei Löt-Prozesszonen auf, mit einer vorgelagerten Konvektions-Prozesszone, einer Kondensations-Prozesszone und einer nachgelagerten Konvektions-Prozesszone. Dadurch wird die Flexibilität bei der Umsetzung eines "Reflow-Profils" weiter erhöht. In einem Mischbetrieb kann die nachgelagerte Konvektions-Prozesszone als Kühlzone konfiguriert werden während die vorgelagerte Konvektions-Prozesszone als Vorheizzone konfiguriert werden kann. Der Peakbereich kann wieder in der Kondensations-Prozesszone umgesetzt werden.

Der Peakbereich kann auch allein in der vorgelagerten Konvektions-Prozesszone umgesetzt werden. In diesem Fall kann die Kondensations-Prozesszone abgeschaltet werden, wodurch der Durchsatz erhöht werden kann. Eine solche Betriebsweise wäre beispielsweise möglich, wenn die Unterschiede der thermischen Massen der Bauelemente nicht zu groß sind.

Weiterhin hilft die Trennung des Lötprozesses in drei separate Abschnitte mit unterschiedlichem Wärmeübertragungsmechanismen dabei, das Verschmutzungsproblem zu minimieren. In der Vorheizung unter Konvektion werden bereits viele Stoffe aus dem Lötgut ausgetrieben, die dann nicht mehr die hermetisch dichte Lötkammer (Peak) kontaminieren können.

In einer weiteren Ausführungsform weist die Reflow-Lötanlage eine mehrere Segmente umfassende Fördereinrichtung auf, um das Werkstück durch die Löt-Prozesszonen und von einer Löt-Prozesszone zur Nächsten zu befördern. Weiterhin ist die Kondensations-Prozesszone konfiguriert, wahlweise als eine hermetisch dichte Prozesskammer zu arbeiten oder der Fördereinrichtung ein ungehindertes Passieren von Werkstücken zu erlauben. Dadurch wird eine technische Umsetzung des wahlweisen Betriebs der Reflow-Lötanlage als Kondensationslötanlagen, Konvektionslötanlage oder kombinierte Lötanlage realisiert. Die Ausbildung der Kondensationsprozesszone als eine Einrichtung, die sowohl als hermetisch dichte Prozesskammer (geschlossenes System) als auch als offenes System in einem inaktiven Zustand arbeitet erlaubt den "wahlweisen" Anschluss des geschlossenen Systems an das offene System. Durch die segmentierte Fördereinrichtung können die Löt-Prozesszonen flexibel kombiniert werden und ein optimaler Workflow kann erreicht werden.

Erfindungsgemäß umfasst die Reflow-Lötanlage weiterhin eine Steuerungseinrichtung, die die Segmente der Fördereinrichtung individuell steuern kann, und die die Reflow-Lötanlage so steuern kann, dass sie wahlweise folgende Betriebsmodi ermöglicht:
- Modus 1: reine Konvektionslötanlage mit abgeschalteter Kondensationsprozesszone,
- Modus 2: reine Kondensationslötanlage mit abgeschalteter Konvektions-Prozesszone, und
- Modus 3: kombinierte Lötanlage mit beliebiger Kombination von Komponenten der Konvektions-Prozesszone und der Kondensationsprozesszone, um komplexe Lötprofile umzusetzen.

Die Steuerungseinrichtung erlaubt deshalb eine Vorkonfiguration der Reflow-Lötanlage abhängig von den Betriebsmodi, wodurch die Bedienung erleichtert wird.

In einer weiteren Ausführungsform ist die hermetisch dichte Prozesskammer als eine erste Halbschale und eine zweite Halbschale ausgebildet, wobei mindestens eine der Halbschalen senkrecht zu einer Transportrichtung der Fördereinrichtung bewegbar ist, so dass die hermetisch dichte Prozesskammer einen geöffneten Zustand einnehmen kann, bei dem ein gefördertes Werkstück in die und aus der Kondensations-Prozesszone gebracht werden kann. Die Realisierung der hermetisch dichten Prozesskammer als Halbschalen ermöglicht die Integration der geschlossenen Kondensations-Prozesszone in die offene Konvektions-Prozesszone mit wahlweise Zuschaltung oder Abschaltung der Kondensations-Prozesszone wobei der Workflow aufrechterhalten werden kann.

In einer Ausführungsform davon umfasst die erste und die zweite Halbschale jeweils eine Heizvorrichtung zum Heizen der ersten und der zweiten Halbschale von außen und/oder innen. Mit dieser Maßnahme wird das Problem der thermischen Stabilisierung gelöst, das auftritt, wenn ein geschlossenes System mit einem offenen System kombiniert wird. Wie oben bereits erwähnt wurde, entsteht nicht genügend Gas, um einen Kondensationslötprozess zu gestalten, wenn die inneren Kammerwände nicht auf einer höheren Temperatur über dem Siedepunkt des Kondensations-Mediums Galden liegen. Bei Integration des geschlossenen Systems in das offene System muss zwangsläufig das geschlossene System geöffnet werden, um den Übergang von Baugruppen von einem System ins Andere zu ermöglichen. Dies erschwert die thermische Stabilisierung des geschlossenen Systems. Mit den Heizvorrichtungen in/an den Halbschalen wird dieses Problem gelöst.

In einer weiteren Ausführungsform sind an oder nahe an der hermetisch dichten Prozesskammer Ventile zum Öffnen und Verschließen von Fluidleitungen angebracht, um dampfförmiges und/oder kondensiertes Galden zuzuführen und abzusaugen. Mit dieser Maßnahme wird das Problem der Querkontamination gelöst, das auftritt, wenn das geschlossene System des Kondensationsprozesses in das offene System des Konvektionsprozesses integriert wird. Beim Öffnen der Kammer des geschlossenen Systems kann Fluid (insbesondere Galdengas) aus der Kammer entweichen und im offenen Konvektionssystem kondensieren. Weiterhin kann das Fluid auch in den Fluidleitungen kondensieren und das Kreislaufsystem verschmutzen. Um dies zu verhindert werden alle Fluidleitungen mit geeigneten Ventilen dicht an der Kammer verschlossen. Damit wird auch verhindert, dass bereits injiziertes Galden sofort wieder abfließen kann bevor daraus der für den Kondensationsprozess notwendige Volumenanteil Gas generiert wurde. Zusätzlich wird nach dem Kondensationsprozess sämtliches Fluid aus der Kammer abgesaugt, um ein Ausströmen von Galden nach dem Öffnen der geschlossenen Kammer in das Konvektionssystem zu verhindern.

In einer weiteren Ausführungsform weist die Reflow-Lötanlage weiterhin eine Einrichtung zur Drucksteuerung eines Kondensationsprozesses auf. Mit einer Drucksteuerung lässt sich der Kondensations-Prozess und damit die Einstellung der Peaktemperatur zum Durchführen des Lötvorgangs besser regulieren. Diese Maßnahme wird unterstützt durch einen Drucksensor, der in der hermetisch dichten Prozesskammer angeordnet ist. Beispielsweise kann während einer Phase des Kondensationslötens die Siedetemperatur des Mediums durch den Druck in der Kammer beeinflusst werden. Damit muss auch kein Kondensations-Medium (Typ des Galden) gewechselt werden, wenn ein anderes Lot-Material mit anderem Schmelzpunkt verwendet wird.

In einer weiteren Ausführungsform weist die Reflow-Lötanlage weiterhin eine Einrichtung zum Durchführen eines Vakuumprozesses auf. Ein Vakuumprozess verbessert die Qualität der Lötstelle.

In einer weiteren Ausführungsform ist die Einrichtung zum Durchführen eines Vakuumprozesses mit der hermetisch dichten Prozesskammer funktionell verbindbar. Die hermetisch dichte Prozesskammer bietet sich an, auf einfache Weise, einen Vakuumprozess durchzuführen. In der dazu notwendigen hermetisch dichten Kammer können sowohl der Kondensationsprozess zur Wärmeübertragung als auch ein (oder mehrere) Vakuumprozess(e) abgebildet werden. Eine Verbindung des Vakuumprozesses mit dem Kondensationsprozess bietet eine Reihe von Vorteilen. Der Kondensationsprozess kann beispielsweise mit einem Vakuumprozess begonnen werden, nachdem das Lötgut in der Kammer ist und diese vollständig geschlossen ist. In den luftleeren Raum wird nun Galden injiziert. Das Galdengas breitet sich in der Kammer vollständig aus, wodurch folgende Effekte erreicht werden:
a) Das kondensierende Gas erwärmt die Kammerwände von innen und hilft so dabei, die Kammer thermisch zu stabilisieren. Der Galdenbedarf kann hierdurch wesentlich reduziert werden.
b) Das Gas kondensiert entsprechend seinem Partialdruck zunächst bei niedrigen Temperaturen, wodurch es möglich wird, Lötprozesse bei kleineren maximalen Temperaturen durchzuführen, als es dem Siedepunkt des Galden bei 1000 mbar entspricht. So ist es z.B. möglich einen bleihaltigen Prozess (SnPb37, 183 °C Schmelzpunkt) mit demselben Galden HS 240 durchzuführen, wie den üblichen bleifreien Prozess (SnAg3,0Cu0,5, 217 °C).
c) Der Vakuumprozess vor der Injektion hilft auch dabei, das Lötgut (insbesondere die Lotpaste) vor dem Löten zu trocknen, um z.B. Voids (Poren) und Lotspritzer zu minimieren.

In einer weiteren Ausführungsform kann zur Durchführung des Kondensationsprozesses ein zu kondensierendes Medium in flüssiger Form oder als Dampf der hermetisch dichten Prozesskammer zugeführt werden.

In noch einer anderen Ausführungsform weist mindestens eine der Konvektions-Prozesszonen eine Vielzahl von Konvektionsmodulen mit unabhängiger Temperatursteuerung auf, um mindestens 2, bevorzugt 3, bevorzugter 4, 5, 6, 7, 8 oder 9 Heizzonen und/oder Kühlzonen zu bilden. Dadurch können sehr flexibel sehr komplexe Reflow-Profile umgesetzt werden.

### Kurze Beschreibung der Figuren

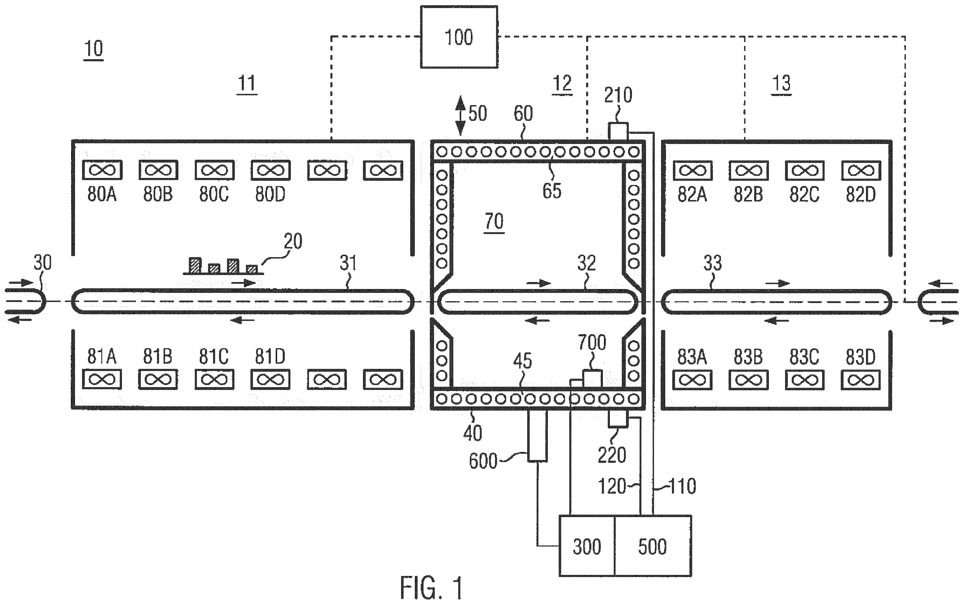

Die vorliegende Erfindung wird nun anhand der folgenden Figur beschrieben, in der Fig. 1 eine schematische Übersicht einer Reflow-Lötanlage gemäß der vorliegenden Erfindung zeigt.

### Ausführliche Beschreibung

Das Konzept der vorliegenden Erfindung beruht auf dem eingangs genannten Problem, dass erhöhte Qualitätsanforderungen bei der Leiterplattenherstellung sowie neue Anwendungen der Leistungselektronik in Fahrzeugen flexiblere Umsetzungen von Reflow Profilen erfordern. Obwohl eine Vergrößerung des Maschinenparks zur Umsetzung unterschiedlicher Löt-Prinzipien bei einem Hersteller eine Lösungsmöglichkeit wäre, fehlt dazu meistens der Platz und das Geld für die notwendigen Investitionen. Aus dieser Problemlage heraus entsteht das Konzept, mehrere Löt-Prinzipien in einer Anlage zu integrieren. Das Kondensationslöten umgeht viele der Nachteile des Konvektionslötens, und umgekehrt. Eine Kombination dieser zwei Löt-Prinzipien in einer Anlage wurde jedoch nie umgesetzt, da es sich bei dem Konvektionslöten um ein offenes System mit entsprechenden Vorteilen handelt, während das Kondensationslöten ein geschlossenes System mit entsprechend anderen Vorteilen benötigt. Bei der Kombination eines offenen Systems mit einem geschlossenen System gehen allerdings manche Vorteile des jeweiligen offenen oder geschlossenen Systems verloren. Beispielsweise ist bei der Integration des geschlossenen Systems im offenen System der Workflow des offenen Systems unterbrochen und der Durchsatz geht zurück. Andererseits gehen die Vorteile des geschlossenen Systems bezüglich Kontamination bei der Integration in ein offenes System verloren. Das geschlossene System muss im offenen System geöffnet werden, so dass eine Querkontamination stattfinden kann.

Das Konzept der vorliegenden Erfindung, ein Konvektionssystem mit einem Kondensationssystem in einer Anlage zum Kombinieren, beruht daher auf der Analyse eines komplexen und vielschichtigen Problems, das zu einer Problemlösung führt, bei der ein Konvektionssystem mit einem Kondensationssystem so kombiniert wird, dass "wahlweise" nur Konvektionslöten, nur Kondensationslöten oder eine Kombination daraus zur Anwendung kommt. Damit ist eine einzige Anlage in der Lage je nach Werkstück einen optimalen Prozess durchzuführen, und die Vorteile der einzelnen Löt-Prinzipien optimal zu nutzen. Dieses Konzept wird ergänzt durch Ausführungsformen, in denen technische Details einer möglichen Umsetzung der Möglichkeit zur Auswahl von Löt-Prinzipien und deren Kombination definiert werden.

Figur 1 zeigt eine Übersicht der vorliegenden Erfindung, in der alle beschriebenen Ausführungsformen veranschaulicht werden. Anzumerken ist, dass Figur 1 auch optionale Merkmale enthält, die nicht als essenzielle, für die Erfindung notwendige, Merkmale angesehen werden, die die Erfindung jedoch vorteilhaft weiterbilden.

In Figur 1 bezeichnet das Bezugszeichen 10 eine Reflow-Lötanlage. Die Bezugszeichen 11, 12 und 13 bezeichnen Löt-Prozesszonen. Insbesondere bezeichnet das Bezugszeichen 11 eine vorgelagerte Konvektions-Prozesszone, das Bezugszeichen 12 eine Kondensations-Prozesszone und das Bezugszeichen 13 eine nachgelagerte Konvektionszone. Das Bezugszeichen 20 bezeichnet ein zu lötendes Werkstück. Das Bezugszeichen 30 bezeichnet eine segmentierte Fördereinrichtung mit den Fördersegmenten 31, 32 und 33. Das Fördersegment 31 ist der vorgelagerten Konvektionszone 11 zugeordnet, das Fördersegment 32 ist der Kondensations-Prozesszone zugeordnet und das Segment 33 ist der nachgelagerten Konvektions-Prozesszone zugeordnet. Die Bezugszeichen 40 und 60 bezeichnen eine untere Halbschale 40 und eine obere Halbschale 60, die im geschlossenen Zustand eine hermetisch dichte Prozesskammer 70 bilden. Die Bezugszeichen 45 und 65 bezeichnen ein Heizsystem 45 für die untere Halbschale 40 und ein Heizsystem 65 für die obere Halbschale 60. Wie in Figur 1 zu sehen ist, sind die Fördersegmente 31, 32, 33 so unterbrochen, dass das Fördersegment 32, das der Kondensations-Prozesszone 12 zugeordnet ist, vollständig von der hermetisch abgedichteten Prozesskammer 70 aufgenommen werden kann.

Obwohl die Heizsysteme 45 und 65 als innerhalb der Wände der Halbschalen dargestellt sind, sollte man wissen, dass die Heizsysteme an den Innenwänden oder bei ausreichender thermischer Leitfähigkeit auch an den Außenwänden der Halbschalen angeordnet sein können.

Weiter mit Bezug auf Figur 1, bezeichnet das Bezugszeichen 50 (Doppelpfeil) die Richtungen, in der die obere Halbschale bewegt werden kann, um die hermetisch dichte Prozesskammer 70 zu öffnen und zu schließen. Obwohl in Figur 1 nur die obere Halbschale 60 als beweglich dargestellt ist, sollte man wissen, dass auch die untere Halbschale 40 beweglich ausgeführt sein kann.

Figur 1 zeigt weiterhin, dass die Konvektions-Prozesszonen 11 und 13 mit einer Vielzahl von Konvektionsmodulen ausgestattet sind, wobei die Bezugszeichen 80A bis 80D Konvektionsmodule oberhalb eines Werkstücks 20 in der vorgelagerten Konvektions-Prozesszone 11 bezeichnen, die Bezugszeichen 81A bis 81D Konvektionsmodule unterhalb eines Werkstücks 20 in der vorgelagerten Konvektions-Prozesszone 11 bezeichnen, die Bezugszeichen 82A bis 82D Konvektionsmodule oberhalb eines Werkstücks 20 in der nachgelagerten Konvektions-Prozesszone 13 bezeichnen und die Bezugszeichen 83A bis 83D Konvektionsmodule unterhalb eines Werkstücks 20 in der nachgelagerten Konvektions-Prozesszone 13 bezeichnen. Obwohl hier nur vier Module pro Modulgruppe gezeigt sind, sollte man wissen, dass zur ausreichenden Löt-Profilierung auch mehr als vier Konvektionsmodule pro Gruppe verwendet werden können. Beispielsweise können 3, 4, 5, 6, 7, 8, 9, 10, 11 und mehr Module pro Prozesszone üblich sein.

Die Konvektionsmodule 80A bis 80D, 81A bis 81D, 82A bis 82D und 83A bis 83D können in Form von Lochdüsenfeldern mit spezieller Lochdüsengeometrie ausgebildet sein, durch die erwärmtes oder gekühltes Schutzgas, beispielsweise Stickstoff, strömen kann, wodurch eine homogene und lückenlose Wärmeübertragung auf eine Leiterplatte/Werkstück möglich wird. Die Lochdüsen der Konvektionsmodule sorgen für ein gleichmäßiges Anströmen der Werkstücke wobei die Temperatur für jede Zone beispielsweise über eine Lüfterfrequenz steuerbar sein kann. Die Transport- und Strömungsgeschwindigkeiten können für die Konvektionsmodule getrennt voneinander regelbar sein. Mit einer solchen Anordnung sind präzise Wärmeprofile möglich, beispielsweise mit einer Vorheizzone, die auch zur Durchführung einer Pyrolyse geeignet ist, einer Peakzone zum Schmelzen des Lots und einer Kühlzone.

Figur 1 zeigt weiterhin eine Steuerungseinrichtung 100, mit der die Segmente 31, 32, 33 der Fördereinrichtung 30 individuell gesteuert werden können. Weiterhin kann die Steuerungseinrichtung 100 die Reflow-Lötanlage 10 so steuern, dass wahlweise bestimmte Betriebsmodi möglich sind.

Beispielsweise kann die Steuerungseinrichtung 100 die Reflow-Lötanlage 10 in einem Modus als reine Konvektionslötanlage mit abgeschalteter Kondensationsprozesszone 12 betreiben. In diesem Fall steuert die Steuerungseinrichtung 100 die Kondensations-Prozesszone 12 so an, dass die obere Halbschale 60 von der unteren Halbschale 40 abgehoben ist, um die hermetisch abdichtbare Prozesskammer 70 zu öffnen. Das der Kondensations-Prozesszone 12 zugeordnete Segment 32 der Fördereinrichtung 30 wird dann so angesteuert, dass Werkstücke 20 von der als Heizzone angesteuerten vorgelagerten Konvektions-Prozesszone 11 zur als Kühlzone angesteuerten nachgelagerten Konvektions-Prozesszone 13 möglichst schnell transportiert werden.

Gemäß einem anderen Modus kann die Steuerungseinrichtung 100 die Reflow-Lötanlage 10 als reine Kondensationslötanlagen mit abgeschalteten Konvektions-Prozesszonen 11 und 13 betreiben. In diesem Fall schaltet die Steuerungseinrichtung 100 die Konvektionsmodule 80A bis 80D, 81A bis 81D, 82A bis 82D und 83A bis 83D in den Konvektions-Prozesszonen 11 und 13 ab. Die den Konvektions-Prozesszonen 11 und 13 zugeordneten Segmente 31 und 32 der Fördereinrichtung 30 werden dann so angesteuert, dass Werkstücke 20 in die Kondensations-Prozesszone 12 bzw. aus ihr heraus transportiert werden, wenn die hermetisch abdichtbare Prozesskammer 70 geöffnet ist. Weiterhin steuert die Steuerungseinrichtung 100 die Reflow-Lötanlage 10 so, dass ein Kondensations-Lötprozess durchgeführt wird, wenn sich ein Werkstück 20 in der hermetisch dichten Prozesskammer 70 befindet, d.h. wenn sich die hermetisch dichte Prozesskammer 70 in einem geschlossenen Zustand befindet.

Gemäß einem weiteren Modus, der im Folgenden als Mischmodus bezeichnet wird, wird die Reflow-Lötanlage 10 als kombinierte Lötanlage mit beliebiger Kombination von Komponenten der Konvektions-Prozesszonen 11, 13 und der Kondensationsprozesszone 12 betrieben, um komplexe Lötprofile umzusetzen. Beispielsweise können die Konvektionsmodule 80A bis 80D und 81A bis 81D der vorgelagerten Konvektions-Prozesszone 11 so eingestellt werden, dass sie ein Vorheizprofil, optional mit einer Pyrolysefunktion an den Konvektionsmodulen 80D und 81D umsetzen. Der eigentliche Lötvorgang findet dann in der Kondensations-Prozesszone 12 statt. Die Konvektionsmodule 82A bis 82D und 83A bis 83D der nachgelagerten Konvektions-Prozesszone 13 können dann so eingestellt werden, dass eine kontrollierte Kühlung erfolgt. Die Segmente 31, 32 und 33 der Fördereinrichtung 30 können dann so angesteuert werden, dass ein optimaler Kompromiss entsteht zwischen Maximierung des Durchsatzes und Präzision der Lötstellen.

Figur 1 zeigt weiterhin Ventile 210, 220, die unmittelbar an den jeweiligen Halbschalen 40 bzw. 60 der Kondensations-Prozesszone 12 angebracht sind, durch die die Fluidleitungen 110, 120 an die hermetisch dichte Prozesskammer 70 angeschlossen werden können. Durch die Ventile kann verhindert werden, dass das Kondensationsmittel Galden unkontrolliert aus der Prozesskammer 70 austreten kann. Beispielsweise kann eine Steuerung 300, die auch in der Steuerungseinrichtung 100 integriert sein kann, dass Zulaufventil 210 öffnen und ein Fluid Handling System 500 anweisen, dampfförmiges Galden über die Fluidleitung 110 durch das Zulaufventil 210 in die hermetisch dichte Prozesskammer 70 einzuspritzen. Nach dem Kondensationsprozess kann die Steuerung 300 das Absaug-Ventil 220 öffnen und das Fluid Handling System 500 anweisen, dampfförmiges und kondensiertes Galden aus der hermetisch dichten Prozesskammer 70 abzusaugen. In dem Fluid Handling System 500 kann auch eine Reinigung des verbrauchten Galden vorgenommen werden, um es für einen anschließenden Kondensationsprozess wieder zu verwenden.

Figur 1 zeigt weiterhin einen Drucksensor 700 mit einem Messbereich von beispielsweise 0-1500 mbar, der den Innendruck der hermetisch abgedichteten Prozesskammer 70 messen kann. Die Steuerung 300 kann den gemessenen Druck dazu verwenden, eine Pumpe in dem Fluid Handling System 500 zu steuern, so dass ein bestimmter Druck im Inneren der hermetisch dichten Prozesskammer 70 herrscht. Über diesen Druck kann zum Beispiel die Peaktemperatur geregelt werden.

In dem Fluid Handling System 500 kann beispielsweise auch die Infrastruktur der Galdenversorgung untergebracht werden. Dabei kann das Fluid Handling System 500 als ein separates Modul an eine bestehende Konvektionslötanlage mit Vakuumoption angedockt werden. Dieses Modul beinhaltet sowohl die Galdenversorgung als auch die Galdenreinigung. Dieses Modul könnte dann jeder Zeit und mit einem sehr geringen Aufwand von der Anlage getrennt werden.

Figur 1 zeigt weiterhin eine Einrichtung 600 zum Durchführen eines Vakuumprozesses, die mit der hermetisch abgedichteten Kammer 70 funktional verwendbar ist. Die Steuerung 300 kann mit den Druck-Informationen des Drucksensors 700 die Einrichtung 600 zur Durchführung eines Vakuumprozesses so steuern, dass ein Vakuumprozess mit einem vorbestimmten Unterdruck durchgeführt werden kann, um das Lötgut vor dem Löten zu trocknen und um Voids und Lotspritzer zu minimieren.

Ein beispielhaftes Verfahren für einen Mischbetrieb der erfinderischen Reflow-Lötanlage umfasst folgende Schritte:
1. Einstellen eines gewünschten Temperaturprofils in der vorgelagerten Konvektions-Prozesszone 11 zum Vorheizen;
2. Einstellen eines gewünschten Temperaturprofils in der nachgelagerten Konvektions-Prozesszone 13 zum Kühlen;
3. Öffnen der hermetisch abdichtbaren Prozesskammer 70;
4. Veranlassen, dass ein Werkstück 20 die vorgelagerte Konvektions-Prozesszone 11 zum Vorheizen durchläuft;
5. Einführen des vorgeheizten Werkstücks 20 in die hermetisch abdichtbare Prozesskammer 70;
6. Schließen und Abdichten der hermetisch abdichtbaren Prozesskammer 70;
7. Durchführen des Kondensations-Lötprozesses;
8. Öffnen der hermetisch abdichtbaren Prozesskammer 70;
9. Weiterleiten des gelöteten Werkstücks 20 an die nachgelagerte Konvektions-Prozesszone 13, um eine kontrollierte Abkühlung des Werkstücks 20 zu bewirken.

Ein beispielhafter Kondensationsprozess kann folgende Schritte umfassen:
1. Beginn des Kondensationsprozesses mit einem Vakuumprozess, nachdem das Lötgut in der Kammer ist und diese vollständig geschlossen ist.
2. Injizieren von Galden in den luftleeren Raum.
3. Zulassen, dass sich das Galdengas in der Kammer vollständig ausbreitet und ein vorbestimmter Druck eingehalten wird.
4. Kondensieren des Galdengases am Werkstück, wobei das Lot schmilzt.

Die vorangegangene ausführliche Beschreibung der Erfindung anhand von Figur 1 soll nicht so aufgefasst werden, dass alle Merkmale der Figur 1 kollektiv einen essenziellen Bestandteil der Erfindung darstellen. Figur 1 dient nur der Veranschaulichung und fasst eine Vielzahl von möglichen Ausführungsformen zusammen. Die essenziellen Merkmale werden im beiliegenden Anspruch 1 angegeben. Besondere Ausführungsformen werden in den abhängigen Ansprüchen definiert.

## Patentansprüche

1. Reflow-Lötanlage (10) mit mehreren individuell beheizbaren Löt-Prozesszonen (11, 12, 13) mit mindestens einer Kondensations-Prozesszone (12) und mindestens einer Konvektions-Prozesszone (11, 13),
**gekennzeichnet durch**
eine mehrere Segmente (31,32,33) umfassende Fördereinrichtung (30), und
eine Steuerungseinrichtung (100), die die Segmente (31,32,33) der Fördereinrichtung (30) individuell steuern kann, um das Werkstück (20) durch die Lötprozesszonen und von einer Lötprozesszone zur Nächsten zu befördern, und die die Reflow-Lötanlage (10) so steuern kann, dass sie wahlweise folgende Betriebsmodi ermöglicht:
Modus 1: reine Konvektionslötanlage mit abgeschalteter Kondensationsprozesszone (12),
Modus 2: reine Kondensationslötanlage mit abgeschalteter Konvektions-Prozesszone (11, 13), und
Modus 3: kombinierte Lötanlage mit beliebiger Kombination von Komponenten der Konvektions-Prozesszone (11, 13) und der Kondensationsprozesszone (12), um komplexe Lötprofile umzusetzen,
so dass die Reflow-Lötanlage (10) konfiguriert ist, einem Werkstück (20) Wärme wahlweise durch Kondensation oder durch Konvektion oder als Kombination aus Konvektion und Kondensation zuzuführen.

2. Reflow-Lötanlage (10) nach Anspruch 1, wobei die Reflow-Lötanlage (10) mindestens eine Kondensations-Prozesszone (12) und mindestens eine dazu vorgelagerte oder nachgelagerte Konvektions-Prozesszone (11, 13) aufweist.

3. Reflow-Lötanlage (10) nach Anspruch 1, wobei die Reflow-Lötanlage (10) eine vorgelagerte und eine nachgelagerte Konvektions-Prozesszone (13) aufweist.

4. Reflow-Lötanlage (10) nach Anspruch 2 oder 3, wobei die Kondensations-Prozesszone (12) konfiguriert ist, wahlweise als eine hermetisch dichte Prozesskammer (70) zu arbeiten oder der Fördereinrichtung (30) ein ungehindertes Passieren von Werkstücken erlaubt.

5. Reflow-Lötanlage (10) nach Anspruch 4 wobei die hermetisch dichte Prozesskammer (70) als eine erste Halbschale (40) und eine zweite Halbschale (60) ausgebildet ist, wobei mindestens eine der Halbschalen (40, 60) senkrecht zu einer Transportrichtung der Fördereinrichtung (30) bewegbar ist, so dass die hermetisch dichte Prozesskammer (70) einen geöffneten Zustand einnehmen kann, bei dem ein gefördertes Werkstück (20) in die und aus der Kondensations-Prozesszone (12) gebracht werden kann.

6. Reflow-Lötanlage (10) nach Anspruch 5, wobei die erste und die zweite Halbschale (40, 60) jeweils eine Heizvorrichtung (45, 65) zum Heizen der ersten und der zweiten Halbschale (40, 60) von außen und/oder innen umfasst.

7. Reflow-Lötanlage (10) nach einem der Ansprüche 4 - 6, wobei an oder nahe an der hermetisch dichten Prozesskammer (70) Ventile (210, 220) zum Öffnen und Verschließen von Fluidleitungen (110, 120) angebracht sind, um dampfförmiges und oder kondensiertes Galden zuzuführen und abzusaugen.

8. Reflow-Lötanlage (10) nach einem der Ansprüche 1 - 7, die weiterhin eine Einrichtung (300) zur Drucksteuerung eines Kondensationsprozesses aufweist.

9. Reflow-Lötanlage (10) nach Anspruch 8, wobei die hermetisch dichte Prozesskammer (70) einen Drucksensor (400) aufweist.

10. Reflow-Lötanlage (10) nach Anspruch 8 oder 9, die ausgelegt ist, während einer Phase des Kondensationslötens die Siedetemperatur des Mediums durch den Druck in der Kammer zu beeinflussen.

11. Reflow-Lötanlage (10) nach einem der Ansprüche 1 - 10, die weiterhin eine Einrichtung (600) zum Durchführen eines Vakuumprozesses aufweist.

12. Reflow-Lötanlage (10) nach Anspruch 11 und einem der Ansprüche 4 - 10, wobei die Einrichtung (600) zum Durchführen eines Vakuumprozesses mit der hermetisch dichten Prozesskammer funktionell verbindbar ist.

13. Reflow-Lötanlage (10) nach einem der Ansprüche 1 - 12, wobei ein zu kondensierendes Medium vorzugsweise flüssig aber auch als Dampf der hermetisch dichten Prozesskammer zugeführt werden kann.

14. Reflow-Lötanlage (10) nach einem der Ansprüche 2 - 13, 44-, wobei mindestens eine der Konvektions-Prozesszonen (11, 13) eine Vielzahl von Konvektionsmodulen (80A, 80B, ..., 81A, 81B, ..., 82A, 82B, ..., 83A, 83B) mit unabhängiger Temperatursteuerung aufweist, um mindestens 2, bevorzugt 3, bevorzugter 4, 5, 6, 7, 8 oder 9 Heizzonen und/oder Kühlzonen zu bilden.

## Claims

1. A reflow soldering system (10) comprising a plurality of individually heatable soldering process zones (11, 12, 13) comprising at least one condensation process zone (12) and at least one convection process zone (11, 13),
**characterized by**
a conveyor (30) comprising a plurality of segments (31, 32, 33), and
a control unit (100) that is able to control the segments (31, 32, 33) of the conveyor (30) individually for conveying the workpiece (20) through the soldering process zones and from one soldering process zone to the next, and to control the reflow soldering system (10) such that it selectively allows the following modes of operation:
mode 1: mere convection soldering system with the condensation process zone (12) switched off,
mode 2: mere condensation soldering system with the convection process zone (11, 13) switched off, and
mode 3: combined soldering system with an arbitrary combination of components of the convection process zone (11, 13) and the condensation process zone (12), so as to implement complex soldering profiles,
so that the reflow soldering system (10) is configured to supply heat to a workpiece (20) selectively through condensation or through convection or as a combination of convection and condensation.

2. The reflow soldering system (10) according to claim 1, wherein the reflow soldering system (10) comprises the at least one condensation process zone (12) and the at least one convection process zone (11, 13) located upstream or downstream of the latter.

3. The reflow soldering system (10) according to claim 1, wherein the reflow soldering system (10) comprises an upstream and a downstream convection process zone (13).

4. The reflow soldering system (10) according to claim 2 or 3, wherein the condensation process zone (12) is configured to operate selectively as a hermetically sealed process chamber (70) or to allow the conveyor (30) to pass workpieces unhindered.

5. The reflow soldering system (10) according to claim 4, wherein the hermetically sealed process chamber (70) is configured as a first half-shell (40) and a second half-shell (60), at least one of the half-shells (40, 60) being movable perpendicularly to a conveying direction of the conveyor (30), so that the hermetically sealed process chamber (70) will be able to assume an open state, in which a conveyed workpiece (20) can be moved into and out of the condensation process zone (12).

6. The reflow soldering system (10) according to claim 5, wherein the first and the second half-shell (40, 60) each comprises a heating system (45, 65) for heating the first and the second half-shell (40, 60) from outside and/or from inside.

7. The reflow soldering system (10) according to one of the claims 4 - 6, wherein valves (210, 220) for opening and closing fluid lines (110, 120) are attached to or provided close to the hermetically sealed process chamber (70), so as to supply or suck off vaporous and/or condensed Galden.

8. The reflow soldering system (10) according to one of the claims 1 - 7, which further comprises a unit (300) for controlling the pressure in a condensation process.

9. The reflow soldering system (10) according to claim 8, wherein the hermetically sealed process chamber (70) includes a pressure sensor (400).

10. The reflow soldering system (10) according to claim 8 or 9, which is configured for influencing, during a phase of condensation soldering, the boiling temperature of the medium through the pressure in the chamber.

11. The reflow soldering system (10) according to one of the claims 1 - 10, which further comprises a facility (600) for executing a vacuum process.

12. The reflow soldering system (10) according to claim 11 and one of the claims 4-10, wherein the facility (600) for executing a vacuum process is functionally connectable to the hermetically sealed process chamber.

13. The reflow soldering system (10) according to one of the claims 1 - 12, wherein a medium to be condensed may be supplied to the hermetically sealed process chamber preferably in liquid form but also in vapor form.

14. The reflow soldering system (10) according to one of the claims 2 - 13, wherein at least one of the convection process zones (11, 13) comprises a plurality of convection modules (80A, 80B, ..., 81A, 81B, ..., 82A, 82B, ..., 83A, 83B) with independent temperature control, so as to define at least 2, preferably 3, more preferably 4, 5, 6, 7, 8 or 9 heating zones and/or cooling zones.

## Revendications

1. Installation de brasage par refusion (10) comportant plusieurs zones de processus de brasage (11, 12, 13) pouvant être chauffées individuellement avec au moins une zone de processus à condensation (12) et au moins une zone de processus à convection (11, 13),
**caractérisée par**
un convoyeur (30) comportant plusieurs segments (31, 32, 33), et
un dispositif de commande (100) qui peut commander individuellement les segments (31, 32, 33) du convoyeur (30) afin de transporter la pièce (20) à travers les zones de processus de brasage et d'une zone de processus de brasage à la suivante, et qui peut commander l'installation de brasage par refusion (10) de manière à permettre les modes de fonctionnement suivants :
Mode 1 : installation de brasage par convection pure avec zone de processus à condensation désactivée (12),
Mode 2 : installation de brasage par condensation pure avec zone de processus à convection désactivée (11, 13), et
Mode 3 : installation de brasage combiné avec une combinaison quelconque de composants de la zone de processus à convection (11, 13) et de la zone de processus à condensation (12) pour mettre en œuvre des profils de brasage complexes,
de telle sorte que l'installation de brasage par refusion (10) est configurée pour fournir de la chaleur à une pièce (20) soit par condensation, soit par convection, soit sous la forme d'une combinaison de condensation et de convection.

2. Installation de brasage par refusion (10) selon la revendication 1, dans laquelle l'installation de brasage par refusion (10) comporte au moins une zone de processus à condensation (12) et, en amont ou en aval de celle-ci, au moins une zone de processus à convection (11, 13).

3. Installation de brasage par refusion (10) selon la revendication 1, dans laquelle l'installation de brasage par refusion (10) comporte une zone de processus à convection en amont et en aval (13).

4. Installation de brasage par refusion (10) selon la revendication 2 ou 3, dans laquelle la zone de processus à condensation (12) est configurée soit pour fonctionner comme une chambre de processus hermétiquement fermée (70), soit pour permettre au convoyeur (30) de faire passer les pièces sans entrave.

5. Installation de brasage par refusion (10) selon la revendication 4, dans laquelle la chambre de processus (70) hermétiquement fermée est conçue comme une première demi-coque (40) et une deuxième demi-coque (60), dans laquelle au moins l'une des demi-coques (40, 60) est mobile perpendiculairement à une direction de transport du convoyeur (30), de sorte que la chambre de processus hermétiquement fermée (70) puisse passer à un état ouvert où une pièce transportée (20) peut être introduite dans la zone de processus à condensation (12) et extraite hors de celle-ci.

6. Installation de brasage par refusion (10) selon la revendication 5, dans laquelle les première et deuxième demi-coques (40, 60) comprennent chacune un dispositif de chauffage (45, 65) pour chauffer les première et deuxième demi-coques (40, 60) depuis l'extérieur et/ou depuis l'intérieur.

7. Installation de brasage par refusion (10) selon l'une des revendications 4 à 6, dans laquelle des vannes (210, 220) pour ouvrir et fermer des conduites de fluide (110, 120) sont montées sur la chambre de processus hermétiquement fermée (70) ou à proximité de celle-ci afin d'introduire et d'extraire du fluide Galden sous forme de vapeur et/ou de condensat.

8. Installation de brasage par refusion (10) selon l'une des revendications 1 à 7, comportant en outre un dispositif (300) pour le contrôle de la pression d'un processus à condensation.

9. Installation de brasage par refusion (10) selon la revendication 8, dans laquelle la chambre de processus hermétiquement fermée (70) comporte un capteur de pression (400).

10. Installation de brasage par refusion (10) selon la revendication 8 ou 9, conçue pour influencer la température d'ébullition du fluide grâce à la pression dans la chambre pendant une phase de brasage par condensation.

11. Installation de brasage par refusion (10) selon l'une des revendications 1 à 10, comportant en outre un dispositif (600) pour mettre en œuvre un processus sous vide.

12. Installation de brasage par refusion (10) selon la revendication 11 et l'une des revendications 4 à 10, dans laquelle le dispositif (600) pour mettre en œuvre un processus sous vide peut être connecté fonctionnellement à la chambre de processus hermétiquement fermée.

13. Installation de brasage par refusion (10) selon l'une des revendications 1 à 12, dans laquelle un fluide à condenser peut de préférence être introduit dans la chambre de processus hermétiquement fermée sous forme d'un liquide mais également sous forme de vapeur.

14. Installation de brasage par refusion (10) selon l'une des revendications 2 à 13, dans laquelle au moins l'une des zones de processus à convection (11, 13) comporte une pluralité de modules de convection (80A, 80B, ... , 81A, 81B, ... , 82A, 82B, ... , 83A, 83B) dont la température est contrôlée indépendamment, pour former au moins 2, de préférence 3, de préférence encore 4, 5, 6, 7, 8 ou 9 zones de chauffage et/ou zones de refroidissement.
